(19) Europäisches Patentamt
European Patent Office
Office européen des brevets

(11) EP 1 990 845 B1

(12) **EUROPEAN PATENT SPECIFICATION**

(45) Date of publication and mention of the grant of the patent:
**24.10.2012 Bulletin 2012/43**

(51) Int Cl.:
***H01L 51/52*** *(2006.01)* ***H01L 51/05*** *(2006.01)*
***B82Y 10/00*** *(2011.01)*

(21) Application number: **08158240.5**

(22) Date of filing: **17.01.2005**

(54) **Ambipolar, light-emitting field-effect transistors**

Ambipolare, lichtemittierende Feldeffekttransistoren

Transistors luminescents, ambipolaires à effet de champ

(84) Designated Contracting States:
**DE FR GB**

(30) Priority: **16.01.2004 GB 0400997**

(43) Date of publication of application:
**12.11.2008 Bulletin 2008/46**

(62) Document number(s) of the earlier application(s) in accordance with Art. 76 EPC:
**05701898.8 / 1 711 970**

(73) Proprietor: **Cambridge Enterprise Limited**
**Cambridge**
**CB2 1AQ (GB)**

(72) Inventors:
- **Zaumzeil, Jana**
  **Cambridge, CB2 0HE,**
  **Cambridgeshire (GB)**
- **Sirringhaus, Henning**
  **Cambridgeshire CB3 7PW,**
  **Cambridgeshire (GB)**
- **Chua, Lay-Lay**
  **Singapore 669566 (SG)**
- **Ho, Peter, Kian-Hoon**
  **Singapore 669566 (SG)**
- **Friend, Richard**
  **Cambridge CB3 9LG, Cambridgeshire (GB)**

(74) Representative: **Slingsby, Philip Roy**
**Page White & Farrer**
**Bedford House**
**John Street**
**London, WC1N 2BF (GB)**

(56) References cited:
**WO-A-2004/006353 JP-A- 10 209 459**

- **J. H. SCHÖN ET AL.: "A LIGHT EMITTING FIELD - EFFECT TRANSISTOR" SCIENCE, vol. 290, 3 November 2000 (2000-11-03), pages 963-965, XP002327889**
- **ALINE HEPP ET AL.: "LIGHT-EMITTING FIELD EFFECT TRANSISTOR BASED ON A TETRACENE THIN FILM" PHYSICAL REVIEW LETTER, vol. 91, no. 15, 10 October 2003 (2003-10-10), pages 157406-1-157406-4, XP002327890**

EP 1 990 845 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention concerns a new transistor capable of ambipolar conduction and light-emission from a well defined zone within the channel of the transistor and a method for making the same.

Field-effect transistors (FETs), are three-terminal devices that comprise a source contact, a drain contact, and a gate contact. A semiconductive layer (the "channel") bridges the source and drain contacts, and is itself spaced from the gate contact by an insulating layer called the gate dielectric. In organic transistors, the semiconductive layer is fabricated from a semiconductive organic material. In particular, in polymer transistors, the semiconductive organic layer is fabricated from a semiconductive polymer, typically a Π-conjugated organic polymer. This layer may be deposited in the device by a precursor route or directly by solution processing.

A voltage is applied across the source contact and the drain contact.. Further, in a field effect transistor, a voltage is applied to the gate contact. This voltage creates a field that alters the current-voltage characteristics of the semiconductive layer lying directly next to the gate dielectric by causing accumulation or depletion of charge carriers there. This in turn modulates the channel resistance and the rate at which charges pass from the source to the drain contact (that is, the source-drain current) for a given source-drain voltage.

In principle, organic field effect transistors (FETs) can operate in two modes; either as an n-channel device (where the charges accumulated in the channel are electrons) or a p-channel device (where the charges accumulated in the channel are holes).

Advanced Functional Materials 13 (2003) pg 199-204 presents a new effect influencing the operation of p-channel organic field-effect transistors resulting from the choice of the gate insulator material. This document is not concerned with n-channel conduction. This document investigates a number of gate insulators with varying dielectric constant and polarity. It is reported that p-channel device performance improved with low-*k* insulators.

Specifically, it is stated that a consistent trend emerged of improved hole mobility when low-k insulators were used. An FET hole mobility of $6x10^{-3}$ $cm^2V^{-1}S^{-1}$ is said to be possible in the PTAA derivatives tested. It is hypothesised that the observed effect was due to the change in energetic disorder at the semiconductor/gate dielectric interface. In this regard it is said that low polarity interfaces are shown to be beneficial. It is further said that this leads to trap filling at lower gate potential and that reduced threshold voltages therefore can be attained.

The insulator materials investigated range from silicon dioxide, poly(vinyl phenol) (PVP), poly(methyl methacrylate) (PMMA), poly(vinyl alcohol) (PVA), poly(perfluoroethylene- co-butenyl vinyl ether), cyanopullulane, polyisobutylene, poly(4-methyl-1-pentene), and a copolymer of polypropylene: polylpropylene-*co*-(1-butene)].

It is particularly advantageous to be able to realise both n- and p-channel organic FETs. This opens up the possibility of fabricating complementary circuits with extremely low standby power consumption, as is known in the field of inorganic Si FETs(P. Horowitz and W. Hill, The Art of Electronics, Cambridge University Press, 1989). One particularly simple way to generate a complementary circuit is to realise both n- and p-channel conduction in the same device (simply by selecting an appropriate gate-voltage polarity). Such a device is said to be ambipolar, and has been demonstrated with inorganic amorphous Si (H. Pfleiderer, W. Kusian and B. Bullemer, Siemens Forschungs - Und Entwicklungsberichte - Siemens Research and Development Reports 14 (1985) pp. 114).

However, to date, it has been generally accepted that n-channel organic FETs are limited to special classes of very-high electron-affinity (EA) semiconductors, such as those containing perylenetetracarboxylate diimide/ dianhydride, naphthalenetetracarboxylate diimide/ dianhydride or phthalocyanine units; or those with very small bandgaps(less than or equal to 1.6 eV), which by virtue of their small bandgaps do have very high electron-affinity.

Some specific examples of small molecule n-channel semiconductive materials that have been used are:

- Bis(phthalocyanines) (G- Guillaud, M.A. Sadound and M. Maitrot, Chemical Physics Letters 167 (1990) pg. 503).

- Tetracyanoquinodimethane (A.R. Brown, D.M. de Leeuw, E.J. Lous and E.E. Havinga, Synthetic Metals 66 (1994) pg. 257).

- Dianhydrides and diimides of napthalenetetracarboxylic acids (J.G. Laquindanum, H.E. Katz, A. Dodabalapur and A.J. Lovinger, Journal of the American Chemical Society 118 (1996) pg. 11331; H.E. Katz, A.J. Lovinger, J. Johnson, C. Kloc, T. Siegrist, W. Li, Y-Y. Lin and A. Dodabalapur, Nature 404 (2000) pg. 478.

- Diimides of perylenetetracarboxlic acids (C.D. Dimitrakopoulos and P.R.L. Malenfant, Advanced Materials 14 (2002) pg. 99).

Examples of small molecule n-channel semiconductive materials are also known from Katz et al, Nature 404 (2000) pg. 478-481. This document in fact mentions the possibility of an organic polyimide dielectric. However, no example of a suitable polyimide is given and no information is provided regarding how a suitable polyimide may be

selected. Further, typically polyimides contain 1-5% residual -COOH groups.

Some examples of high electron-affinity oligomer n-channel semiconductive materials that have been used with an inorganic dielectric are:

- α,ω-diperfluorohexylsexithiophene (A. Facchetti, Y. Deng, A. Wang, Y. Koide, H. Sirringhaus, T. Marks and R.H. Friend, Angewangte Chemie International Edition 39 (2000) pg. 4545).

- Quinodal terthiophene (R.J. Chesterfield, C.R. Newman, T.M. Pappenfus, P.C. Ewbank, M.H. Haukaas, K.R. Mann, L.L. Miller and C.D. Frisbie, Advanced Materials 15 (2003) pg. 1278.

An example of a high electron-affinity polymer n-channel semiconductive material that has been used with an inorganic dielectric is:

- Poly(benzobisimidazobenzophenanthroline) (A. Babel and S.A. Jenekhe, Journal of the American Chemical Society 125 (2003) pg. 13656. This is a very high EA polymer with electron-withdrawing imine nitrogens in the stiff polymer backbone.

To date, it also has been generally accepted that materials that do not fall within the above "special classes" do not show and are not expected to show n-channel semiconductor behaviour. As a result, the choice of semiconductor materials for n-channel organic FETs has been severely limited.

Very high-electron affinity materials (and low-bandgap materials) can have their own limitations. For example, they may be unintentionally doped by adventitious impurities, for example, $H^+$, ammonium and metal ions, especially under bias to a permanently conducting state. Therefore it would be advantageous to be able to develop n-channel and ambipolar transistors from a general class of materials with more moderate bandgaps and electron-affinities.

As described in Nature Materials 2 (2003) pg. 678, one of the main difficulties in achieving ambipolar transistor operation is the injection of holes and electrons into a single semiconductor from the same electrode. This electrode needs to have a workfunction that allows injection of holes in the highest occupied molecular orbital (HOMO) of the semiconductor, and the injection of electrons in the lowest unoccupied molecular orbital (LUMO). Consequently, this will result in an injection barrier of at least half of the bandgap energy for one of the carriers.

The above difficulty in achieving the injection of holes and electrons into a single semiconductor from the same electrode, of course, is greatly compounded by the fact that n-channel activity in organic FETs in any case has been difficult to achieve even with the appropriate electron injection. This has led to a general (erroneous) view that electrons are somehow trapped (and thus rendered immobile) in most organic materials, and therefore (again erroneously) no useful n-channel FETs could be made from the vast majority of these materials.

Never the less, this Nature Materials 2 document demonstrates ambipolar transistors using a thermally grown inorganic $SiO_2$ layer as the gate dielectric and heterogeneous blends, consisting of interpenetrating networks of p-type and n-type semiconductors, as the semiconductive layer. A blend of a derivatised C60 (PCBM) which has a very high electron-affinity as the semiconductive electron transporter and OC1C10-PPV polymer as the semiconductive hole transporter is exemplified. The HOMO level of the OC1C10 polymer is aligned with the work function of the gold electrode. A 1.4eV mismatch is reported between the LUMO level of the PCBM and the work function of the gold electrode.

This document also suggests that the lack of ambipolar transistor action in wide bandgap semiconductors is due to the presence of large injection barriers. The reduction of the barrier is suggested by using small bandgap semiconductors. Poly(indenofluorene) is exemplified, which has a bandgap of 1.55eV.

However, the electron field effect mobilities that have been realized in this document are still unacceptably low in the $10^{-5}$ $cm^2$/ Vs domain. (PIF, electron mobility, $5\times10^{-5}$ $cm^2$/ Vs vs hole mobility, $4\times10^{-5}$ $cm^2$/Vs; and for $C_{60}$-OC1C10-PPV, electron mobility, $3\times10^{-5}$ $cm^2$/Vs vs hole mobility, $7\times10^{-4}$ $cm^2$/Vs).

Clearly, the range of ambipolar transistors that may be made according to this teaching is restricted. Further, small bandgap semiconductors with II-II* gap <1.6 eV tend to be relatively less stable since they are vulnerable to unintentional doping, and facile photochemical reactions. On the other hand, electron-conducting blends with $C_{60}$ networks are not only unstable, due to facile chemical reactions of the $C_{60}$ anions and rapid oxygen trapping but suffer also from general instability of the percolation paths due to the recrystallisation of the small molecule electron-acceptor and transporter.

Prior to the above-described Nature Materials 2 document, Science 269 (1995) pg 1560 describes the use of an inorganic gate dielectric and a bilayer of a hole-conductor and electron-conductor to achieve ambipolar transistor behaviour. The electron conductor is $C_{60}$, with electron mobility measured in the range of $10^{-3}$ $cm^2$/Vs. This electron conductor suffers from the same problems as discussed above in relation to the Nature Materials 2 document.

It will be appreciated from the above that the main thrust of the effort to achieve n-channel FETs and ambipolar transistors has focussed on the semiconductive layer, particularly the material used for the semiconductive layer and

the organization, morphology and spatial ordering of the semiconductive material. Typically, semiconductive materials have been tested against an inorganic $SiO_2$ interface. It will be appreciated that this interface is invariably partially hydrated. Further, it will be appreciated that there exists a need for further improvement of n-channel conduction in n-channel organic FETs and ambipolar organic FETs since, currently, a very limited range of organic materials are useable in such devices.

One of the possible applications for ambipolar organic FETs is in light-emitting FETs (LFETs) in which light is emitted from the transistor channel in the ON-state of the device. LFETs are of interest for applications, such as optical signal transduction and communication, and the incorporation of display functions into an integrated transistor circuit without requiring the realization of special light-emitting device structures, such as vertical light-emitting diodes, which might not be compatible with the process flow required for the transistor circuit, or might require additional process step.

Light-emitting transistors (LFETs) have been postulated in the literature (H. Schoen et al., Science 289, 588 (2000) and Science 290, 963 (2000), the papers were later retracted because of scientific fraud, i.e., the experimental data in these papers were manipulated).

However, they have not been fully realized in practice, although light-emission from FET structures has been reported by several groups. Hepp et al. (Phys. Rev. Lett. 91, 157406 (2003)) as well as Santato et al. (Synth. Metals 146, 329 (2004)) reported light-emission from the edge of the drain contact of a vacuum-processed tetracene FET. This device was not in fact operating as an ambipolar device, since the tetracene/$SiO_2$ interface does not support electron conduction. The light-emission was attributed to an overhanging topography profile at the drain electrode, forcing holes to travel through the bulk of the semiconductor. The associated high electric field near the drain contact causes electrons to be injected from the drain terminal. The light was emitted from a zone very close to the drain electrode due to the very low mobility of electrons in this device, and it was not possible to bias the device in such a way that the recombination zone could be moved into the channel of the device.

Light emission has also been reported from FETs based on blends of coevaporated hole-transporting $\alpha$-quinquethiophene, and electron transporting N,N'-ditridecylperylene-3,4,9,10-tetracarboxylic (Appl. Phys. Lett. 85, 1613 (2004)). The electron and hole mobilities in this device were more than one order of magnitude different, implying that light was also emitted very close to the contact from which the low mobility carriers (electrons) were injected.

Light-emission was also reported in a solution-processed FET by Sakanoue (Appl. Phys. Lett. 84, 3037 (2004)) in a device with gold/aluminium or gold/chromium bilayer source/drain contacts. However, the device characteristics did not show evidence of a bipolar conduction regime, and the region from which the light was emitted was not reported. However, due to the lack of evidence for ambipolar conduction in the reported device characteristics one needs to assume that the light was also emitted from a region very close to one of the electrodes.

A proper, truly ambipolar LFET requires a semiconductor capable of ambipolar conduction with electron and hole mobilities which are similar to within an order of magnitude, and the ability to move the position of the recombination zone in the semiconducting layer from which the light is emitted to any position along the channel between the source and drain electrodes by varying the bias voltages applied to the source, drain and gate electrodes. This has not been realized in the prior art. Figure 3a (top) shows the schematic of an ambipolar LFET. If the device is biased such that the gate voltage is set at a value in between the source and drain voltage, a hole accumulation layer is induced near the source electrode and an electron accumulation is induced near the drain electrode. The device operates by flow of holes from the source, and flow of electrons from the drain with recombination in a well-defined recombination zone (8) somewhere along the channel. The position of the recombination zone depends on the relative electron and hole mobilities. If the electron and hole mobilities are well balanced the recombination zone can be moved to the middle of the channel, and in fact to any position from the source to the drain electrodes by changing the bias voltages applied to the device.

Almost all of the published work on n-channel and ambipolar transistors to date has focused on the preparation of organic semiconductors where n-channel conduction can be observed against a (hydrated) $SiO_2$ interface. In the simultaneously filed PCT application entitled "N-channel transistors" (Agent Ref.: 305038WO) a new general design strategy to obtain n-channel conduction (and also ambipolar field-effect conduction) for a far wider range of organic semiconductors than is currently thought possible is disclosed.

The N-channel transistor invention discloses that n-channel field-effect conduction can be stably supported at a dielectric/ semiconductor interface only if the dielectric does not present too high a concentration of chemical moieties that can trap the negative charge-carriers induced in the semiconductor channel by the field effect. Although the dielectric interface is the more important of the two, the dielectric bulk preferably also should be considered, since bulk trap states can still be populated albeit very slowly. The induced charge carriers travel along the interface and therefore are most severely affected by the traps they encounter at the interface. In contrast, the charge carriers must tunnel into the bulk to be trapped there. Nevertheless, the bulk trap states are capable of retaining charge for a long time, which is detrimental to transistor behavior.

The N-channel transistor invention discloses that by appropriate choice of the organic gate insulating material, it is indeed possible to obtain n-channel FETs from a much broader range of organic semiconductors than has been

known hitherto. As such, it provides for the first time the opportunity for n-channel conduction using an organic semiconductor and an organic dielectric. A broad range of poly(p-phenylenevinylene) and poly(fluorene) derivatives and copolymers have been tested successfully by the present inventors. The key is that the organic gate dielectric layer must not contain trapping groups (that lie in energy near to or below the electron-transport level of the organic semiconductor) above a critical concentration. As a result of this invention, the scope for obtaining n-channel organic FETs and ambipolar organic FETs is considerably expanded. It is no longer limited to the organic semiconductor being a very-high electron-affinity semiconductor.

The N-channel transistor invention has identified that the reason why n-channel FETs have been so elusive to date is that the gate dielectrics that have been tested to date (most notably, silicon oxide, poly(methyl methacrylate), poly(vinyl phenol) and poly(imide)) do not satisfy the specifications of the N-channel transistor invention.

The choice of an organic dielectric with a small number of electron trapping groups enables clean ambipolar conduction in a broad range of organic semiconductors, when suitable materials are chosen for source-drain contacts that allow efficient injection of electrons and holes.

The present invention provides a light-emitting transistor according to claim 1.

In one embodiment, the bulk concentration of trapping groups in the gate dielectric layer is less than $10^{18}cm^{-3}$, where a trapping group is a group having (i) an electron affinity $EA_x$ greater than or equal to $EA_{semicond}$ and/or (ii) a reactive electron affinity $EA_{rxn}$ greater than or equal to ($EA_{semicond}$. -2eV).

Reactive traps are those that undergo a subsequent chemical reaction so that the electron becomes trapped in a new (and deep) state that cannot ordinarily re-emit the electron. Hence, the trapping is not reversible. Particularly ubiquitous examples of reactive traps are those with active (acidic) hydrogens, such as -COOH, and $-CR_2OH$ that can irreversibly trap electrons to expel hydrogen.

Non-reactive traps are those that can re-emit the trapped electrons. Reactive traps consume the induced carriers leading to static charging of the dielectric interface and gigantic shifts in threshold voltages, while non-reactive traps lead to loss of charge-carrier mobility. Both of these are detrimental to transistor devices. It is to be noted that the distinction between the two kinds of traps is not always clear-cut, since non-reactive traps in the presence of some impurities (such as $H_2O$) can turn into reactive traps.

The person skilled in the art is credited with knowing if a particular chemical group is capable of acting as a reactive trap, a non-reactive trap, or both, based on common knowledge of electrochemistry

The total concentration of both reactive traps and non-reactive traps is below a critical concentration. It will be appreciated that whether or not a group is a trapping group must be determined by reference to the $EA_{semicond.}$ of the organic semiconductive material which forms the semiconductive layer. Knowing the semiconductive material and thus $EA_{semicond}$, a person skilled in the art will be able to use the analysis and the definitions for $EA_x$ and $EA_{rxn}$ given below, to order all chemical groups present in an organic gate dielectric layer under consideration into two series with respect firstly to $EA_x$ (i.e. according to their non-reactive trapping properties) and secondly to $EA_{rxn}$ (i.e. according to their reactive trapping properties). In the manner described, a person skilled in the art then can use the electron affinity of the semiconductor ($EA_{semicond}$) to provide the cut-off values to identify which groups are not trapping groups and so may be permitted to exist in the gate dielectric layer, and which other groups are trapping groups and so may not be present above the critical concentration in the gate dielectric layer.

Since the induced charge-carrier concentration typically is of the order of $10^{12}$-$10^{13}$ $cm^{-2}$ under normal FET operation, and the traps are filled first before FET conduction can occur, the critical concentration of reactive and non-reactive traps at the semiconductor/gate dielectric interface ($C_{interf}$) needs to be less than $10^{12}$ $cm^{-2}$, preferably less than $10^{11}$ $cm^{-2}$ and more preferably less than $10^{10}$ $cm^{-2}$.

The bulk concentration ($c_{bulk}$) corresponding to an interface concentration of $10^{12}$ $cm^{-2}$ is $10^{18}$ $cm^{-3}$ according to the equation: $C_{interf} = (c_{bulk})^{2/3}$. Thus, the bulk concentration of trapping groups in the dielectric layer must be less than $10^{18}$ $cm^{-3}$. Taking into account interface segregation, the bulk concentration preferably is at least 1-2 orders of magnitude lower. A preferred bulk concentration therefore is below $10^{17}cm^{-3}$.

One can measure the bulk concentration ($c_{bulk}$) of a trapping group of interest in the gate dielectric layer by a number of methods, including by FTIR. Several examples of suitable methods that can be used to measure the bulk concentration ($c_{bulk}$) are given below. These examples take OH groups as the trapping group of interest.

Method (A): Form a film of the test dielectric to a thickness of 50-100 microns on an IR-transparent substrate such as single-side-polished intrinsic Si wafer by drop-casting or blade coating. Measure the IR spectrum in an FTIR instrument. Collect sufficient scans for noise fluctuations to be less than $10^{-4}$ absorbance units. Look up the absorption band positions of the group in standard tables. For oH, this is at ca. 3300 $cm^{-1}$ and also ca.900 $cm^{-1}$. Quantify the band absorption intensities at these wavenumbers. Convert to an effective concentration using literature values for the band absorptivity or calibration values from measuring the absorption spectra of a film of known thickness and with known concentrations of the OH group.

Method (B): Tag the group under test with a suitable fluorine or silicon label using standard gas-chromatography derivatisation methods, for example, by reacting the OH in the gate dielectric material with the appropriate fluoro anhydride. Purify. Make a film about 0.1-1 micron thick on an intrinsic silicon wafer. Carry out a secondary ion mass spectrometry measurement to measure the concentration of the labelled groups in the film after suitable calibration.

Method (C) : Tag the group under test with a suitable fluorescent label using standard biochemical fluorescent probe labelling methods. Purify. Measure fluorescence activity to obtain concentration after suitable calibration.

Electron affinity (EA) is the energy released when the material accepts electrons from vacuum. Electron affinity is not directly related to the polarity of a material nor is there any correlation between electron affinity and dielectric constant.

$EA_{semicond.}$ can be determined from cyclic voltammetry experiments for the organic semiconductor or from its measured ionization energy. The ionization energy (IE) of the organic semiconductor can be determined from standard ultraviolet photoemission experiments, as the onset of the valence band feature in the ultraviolet photoemission spectra. Less preferably, this quantity may also be estimated from standard cyclic voltammetry, as the midpoint potential ($E_o$') of the coupled oxidation and reduction peaks or the onset oxidation potential ($E_{onset}$), in the oxidation scan. This potential is converted to the vacuum energy scale using a standard energy shift: IE = $E_o$' (vs NHE) + 4.8 eV or $E_{onset}$ (vs NHE) + 4.8 eV.

The electron affinity (EA) is calculated from the ionization energy according to the following equation:

$$EA = IE - \Delta E - BE$$

The bandgap ($\Delta$E) is measured using optical absorption for example. The exciton binding energy (BE) is widely held to be 0.4 eV for a number of conjugated polymers.

Alternatively, the EA of the organic semiconductor can be measured in a more direct way by inverse photoemission, or by standard cyclic voltammetry as the midpoint potential ($E_o$') of the coupled reduction and oxidation peaks or the onset reduction potential ($E_{onset}$), in a reduction scan. This potential is converted to the vacuum energy scale using a standard energy shift: IE = $E_o$' (vs NHE) + 4.8 eV or $E_{onset}$ (vs NHE) + 4.8 eV.

For dielectric materials, because of their non-conducting, EA values are far more difficult to measure directly. However EA is a relatively local property of the chemical groups or moieties present in organic materials. In contrast, this is not the case for inorganic materials. Therefore, for the purposes of the present invention, whether an organic gate dielectric layer is compatible with the n-channel activity of a particular semiconductor is determined in part by comparing the individual EA' s of the constituent moieties of the dielectric ($EA_x$ and $EA_{rxn}$) against $EA_{semicond}$. Because gas-phase EAs of a wide range of groups are available in the literature, this provides a useful a priori means to determine the $EA_x$ of a wide range of chemical groups present in candidate dielectrics for screening purposes.

The usual hydrocarbon backbone structural components present in organic dielectrics (such as the aliphatic chains and phenyl/ phenylene units in polyalkylenes, polystyrenes etc) are not pi-extended and their solid state EAs are often < 0 eV. This is far less than the electron affinity of a typical semiconductive material ($EA_{semicond}$), which is typically 2-3 eV (for example for polyfluorenes, polyphenylenes, polythiophenes and their copolymers). Therefore the presence of these units is acceptable in an insulating material for use in the present invention.

Other chemical/structural groups or moieties that are present in the dielectric either by design (as a structural unit, particularly as a repeating unit or end group) or as an impurity (including chain ends, polymerisation defects, stabilizers, catalysts and inadvertent contaminants) however may have considerably larger EAs. The present inventors have identified that in order to ensure that these moieties do not compete for the electrons, certain design rules must be complied with. Separate design rules may be considered in respect of reactive and non-reactive trapping groups. The design rules enable the selection of a desirable gate dielectric material relative to the organic semiconductor to be used. In this sense, the technique is not limited to defining desirable dielectric materials *per se*. Instead, desirable dielectric materials may be defined depending on the organic semiconductor to be used.

<u>Non-reactive trapping groups</u>

For non-reactive traps, the trapping is reversible and so the criteria for a group to be non-trapping is for the solid-state EA for the chemical group in the dielectric material ($EA_x$) to be less than $EA_{semicond}$. By way of example some $EA_x$ values for common groups are shown below. These values are calculated from the gas-phase EA data. The solid state $EA_x$ value is calculated from the gas phase EA by adding the solid-state polarization energy which is taken here to be 1.8 eV as given by M. Pope and C.E. Swenberg, Electronic Processes in Organic Crystals and Polymers (Oxford University Press, 1999.

| | Moiety X | Solid-state $EA_x$ (eV)[a] |
|---|---|---|
| (a) | Aliphatic carbonyl (-CO-, -COO-, -CONR-) and CN | 1.8-2.0 |
| (b) | Aromatic carbonyl (-CO-, -COO-, -CONR-) | 2.0-2.4 |
| (c) | Aromatic fluorocarbons | 2.3 |
| (d) | Quinoxalines | 2.5 |
| (e) | Aliphatic fluorocarbons | 2.8-2.9 |
| (f) | Quinones | 3.4-3.6 |

[a] Obtained by adding the polarization energy (taken to be 1.8 eV for the purposes of the present invention) to the gas-phase EA of appropriate model compounds.

Therefore, for an $EA_{semicond}$ value of 2-3eV, the presence of (a) may be tolerated in the dielectric for some semiconductors. However, the presence of (b)-(d) at a concentration above the critical concentration may not compatible with n-channel activity of many organic semiconductors. Further, the presence of (e)-(f) above the critical concentration will not be compatible with most organic semiconductors. Because there are such a large number of possible moieties, only a few are provided here for analysis. $EA_x$ values for other groups can be determined in the same way.

Reactive traps

Such traps undergo a coupled reaction that makes entrapping impossible. An example of a coupled reaction is the expulsion of a hydrogen atom from moieties with active hydrogens. Once this hydrogen atom is lost (through some other radical reaction or recombination to give hydrogen gas), the electron charge is irreversibly trapped on the moiety until some charge neutralization event occurs. In any case, the initially trapped electron is not re-emitted, and the capacitive charge density of the gate dielectric becomes filled by such immobile charges. In the case of reactive traps, the criteria for a group to be non-trapping requires a consideration of the reaction free energy. The gas phase EA values for reactive traps are not available. Thus, for the purposes of the present invention, it is necessary only to consider the reactive electron affinity for such groups.

Considering the acidic -COOH moiety by way of an example, this moiety is present as an impurity at the sub% level in poly (methyl methacrylate); and at the few % level in polyimides due to incomplete conversion of the precursor material. During reactive trapping, the reaction being considered is:

$$\text{Semicond}^-(s) + \text{Diel-COOH}(s) \rightarrow \text{Semicond}(s) + \text{Diel-COO}^-(s) + \text{H}(s)$$

which represents trapping of the induced electron initially present in the semiconductor (semicond$^-$) onto -COO$^-$ in the dielectric (Diel-COO$^-$) with lost of an H atom.

The exact kinetic mechanism involved does not affect the energetics of the overall reaction, which can be expressed as the sum of two half-reactions:

| | | |
|---|---|---|
| (i) | Semicond (s) $\rightarrow$ Semicond(s) + $e^-$ (g) | $EA_{semicond}$ |
| (ii) | Diel-COOH(s) + $e^-$(g) $\rightarrow$ Diel-COO$^-$(s) + H(s) | $-(EA_{rxn})$ |

Reaction (ii) involves the expulsion of a hydrogen atom. Here the energetics of reaction (ii) is denoted as the negative of the reactive electron-affinity ($EA_{rxn}$). The present invention therefore, defines an $EA_{rxn}$ for reactive traps, which can be estimated using a Born-Haber thermodynamic cycle for a corresponding small molecule model, an example of which is as follows:

| | | |
|---|---|---|
| (ii) (a) | Diel-COOH(s) $\rightarrow$ Diel-COOH(g) | $\Delta G_{subl}$ |
| (ii) (b) | Diel-COOH(g) $\rightarrow$ Diel-COO$^-$(g) + $H^+$(g) | $\Delta G_{deprot}$ |
| (ii) (c) | $H^+$ (g) + $e^-$(g) $\rightarrow$ H (g) | $-\Delta G_{ion,H}$ |
| (ii) (d) | Diel-COO$^-$(g) $\rightarrow$ Diel-COO$^-$(s) | $\Delta G_{polar} - \Delta G_{sub1}$ |
| (ii) (e) | H(g) $\rightarrow$ H(s) | $-\Delta G_{sub1.H}$ |

where the three key energy terms are respectively the gas-phase deprotonation energy ($\Delta G_{deprot}$), the negative of the

H atom ionization energy ($-\Delta G_{ion,H}$ = -13.6 eV), and the medium polarization energy ($\Delta G_{polar}$ taken here to be -1.8 eV) for a small molecule to model Diel-COOH.

The overall energy for reaction (ii) is the sum of these energies, $-EA_{rxn} = \Delta G_{deprot} - \Delta G_{ion,H} + \Delta G_{polar} - \Delta gG_{sub1,H}$ = $\Delta G_{deprot}$ - 15.4 eV. Sublimation energies $\Delta G_{sub1,H}$ are sufficiently small (probably less than 0.1 eV) to be omitted. $\Delta G_{deprot}$ can be obtained from data tables. The primary factor governing whether a chemical group containing active hydrogen may act as a reactive trap is thus its deprotonation energy. $EA_{rxm}$. values obtained in this way for a range of common moieties that may act as reactive traps are tabulated below.

| | Moiety X | $\Delta G_{deprot}$ (eV) | $EA_{rxn}$ (eV) |
|---|---|---|---|
| (a) | Aliphatic-NHR | 16.6 | -1.2 |
| (b) | Aliphatic-OH | 15.9 | -0.5 |
| (c) | Aromatic-NHR | 15.5 | -0.1 |
| (d) | Aliphatic-SH | 15.1 | 0.3 |
| (e) | Aromatic-OH | 14.8 | 0.6 |
| (f) | Aliphatic-COOH | 14.8 | 0.6 |
| (g) | Aromatic-SH | 14.5 | 0.9 |
| (h) | Aromatic-COOH | 14.5 | 0.9 |

By experiment, the present inventors have determined that (e) and (f) generally are incompatible with n-channel FET conduction for a range of organic semiconductors (where $EA_{semicond.} \approx 2 - 2.5$ eV). Therefore, the present inventors propose that in order for a moiety to be non-trapping, its $EA_{rxn}$ should be less than that of $EA_{semicond}$ by at least 2 eV, i.e. $EA_{rxn} < (EA_{semicond} - 2\ eV)$.

Without wishing to be bound by theory, this may be rationalized crudely by considering that the trapping rate ($k_r$) is a product of attempt frequency (v) and the probability of trap occupation ($K$) : $k_r = v K$. The value of K is estimated by standard chemical thermodynamics to be $K = \exp(-\Delta G/kT)$. For $k_r < 10^{-7}\ s^{-1}$ (which corresponds to a characteristic trapping time >100 days for a trap concentration similar to the induced charge concentration) and $v = 10^{15}\ s^{-1}$ (the electronic frequency), we require $K < 10^{-22}$ and hence $\Delta G > 1.5$ eV.

Therefore the analysis indicates that while (a)-(c) may be tolerated in the dielectric, (e)-(h) are not compatible with most organic semiconductors if present above the critical concentration. A similar analysis can be made for any other moieties of interest.

Nevertheless despite (a)-(c) being compatible on reactive EA grounds, these hydrogen bonding moieties tend to be hygroscopic and retain $H_2O$ strongly. $H_2O$ dispersed in the solid film has a high EA ($\approx$ 3.0 eV), which then can make the presence of these moieties again incompatible with n-channel conduction with most organic semiconductors. It is for this reason that the insulating material preferably does not include more than 0.1% by weight -OH groups and other hydrogen-bonding groups. A very small concentration of -OH groups and other hydrogen-bonding groups may be tolerated in the insulating material. Preferably, the insulating polymer contains less than 0.01% by weight -OH groups and other hydrogen-bonding groups, more preferably less than 0.001% by weight -OH groups and other hydrogen-bonding groups. Most preferably the insulating polymer is substantially free of - OH groups and other hydrogen-bonding groups

Taking as an example an organic semiconductor with an $EA_{semicond}$ of 2.5 eV, the following (non-exhaustive) groups if present must not exceed the critical concentration specified earlier: quinoxalines, aliphatic fluorocarbons, quinones, aromatic-OH, aliphatic-COOH, aromatic-SH, aromatic-COOH. The critical bulk concentration has been discussed above.

Organic dielectrics that contain these groups as defects, chain ends, stabilizers or contaminants need to be rigorously purified so that they are present below the critical concentration as discussed above.

The light-emitting transistor may have a top-gate or bottom-gate configuration.

In a light-emitting transistor according to an embodiment of the present invention, the gate dielectric layer may be considered to comprise an organic gate insulating material together with any impurities. The gate dielectric layer preferably does not contain any trapping groups. This ensures that the concentration of trapping groups is below the critical concentration.

More preferably the organic gate insulating material per se does not comprise a repeat unit comprising a trapping group. Most preferably, the organic gate insulating material per se does not contain any trapping groups.

Typically, $EA_{semicond.}$ will be greater than or equal to 2eV, although the present invention is not so limited. Also typically, $EA_{semicond.}$ will be in the range of from 2eV to 4eV, more typically in the range of from 2 eV to 3 eV.

As mentioned above, trapping groups in the insulating material may be a part of the insulating material per se (i.e. excluding impurities) or may be present as an impurity. Trapping groups also may be present as part of a residue

unit that is present in the organic insulating material due to incomplete formation of the organic insulating material during preparation. It will be appreciated that whilst a trapping group may be tolerated as an end group, defect, stabilizer or impurity, it usually will not be tolerated as a repeating unit in the insulating material. This is because, when present as a repeating unit, it may bring the concentration of trapping groups to above the critical concentration. Trapping groups may or may not be tolerated in a residue unit depending on the concentration of residue units in the organic insulating material.

Preferably the insulating material does not contain a repeat unit or residue unit comprising a group having (i) an electron affinity $EA_x$ greater than or equal to 3eV and/or (ii) a reactive electron affinity $EA_{rxn}$ greater than or equal to 0.5eV.

Accordingly, preferably the insulating material does not contain a repeat unit or residue unit comprising a quinone, aromatic -OB, aliphatic -COCH, aromatic -SH, or aromatic - COOH group.

In some embodiments, preferably the insulating material does not comprise a repeat unit or residue unit having an electron affinity $EA_x$ greater than or equal to 2.5eV, more preferably greater than or equal to 2eV. In these embodiments, the insulating material preferably does -not contain a repeat unit and/or residue unit comprising an aliphatic fluorocarbon group. More preferably, the insulating material does not contain a repeat unit and/or residue unit comprising an aromatic carbonyl, quinoxaline or aromatic fluorocarbon group.

Preferably the insulating material per se contains one or more groups independently selected from alkene, alkylene, cycloalkene, cycloalkylene, siloxane, ether oxygen, alkyl, cycloalkyl, phenyl, and phenylene groups. These groups may be substituted or unsubstituted. These groups optionally may be part of a repeat unit of the insulating material.

The insulating material per se may contain one or more groups independently selected from aliphatic carbonyl, cyano, aliphatic -NHR, aromatic -NHR, and. Again, these groups optionally may be part of a repeat unit of the insulating material.

In some embodiments, the insulating material may be made from a precursor to the insulating material. Such a precursor may be converted to the final insulating material by appropriate reaction. For example, where the final insulating material is crosslinked, a precursor insulating material may contain crosslinkable groups and the crosslinked insulating material may be formed from the precursor by heating, for example. Desirable groups to be present in a precursor insulating material include alkene and styrene groups.

In one embodiment the gate dielectric layer preferably comprises an organic insulating polymer. Examples of - insulating polymers which can be used after appropriate purification, are given below:

(i) Poly(siloxanes) and copolymers thereof; such as poly(dimethylsiloxane), poly(diphenylsiloxane-co-dimethylsiloxane), and copolymers thereof.

(ii) Poly(alkenes) and copolymers thereof; such as atactic polypropylene, poly(ethylene-co-propylene), polyisobutylene, poly(hexene), poly(4-methyl-1-pentene) and copolymers thereof;

(iii) Poly(oxyalkylenes) and copolymers thereof, such as poly(oxymethylene), poly(oxyethylene), and copolymers thereof;

(IV) Poly(styrene) and copolymers thereof.

The repeat units in the above polymers, and indeed in any organic insulating polymer useable in the present invention, may be substituted or unsubstituted provided that the final insulating polymers comply with the above design rules. Substituents include functional substituents to enhance particular properties of the polymer such as solubility.

Crosslinked derivatives of the above polymers also are within the scope of the present invention.

Preferably, the insulating material is not a poly(imide).

Preferably the insulating polymer comprises an $Si(R)_2$-O-$Si(R)_2$ unit where each R independently comprises a hydrocarbon. In this regard, a preferred poly(siloxane) as mentioned above is an insulating polymer where the backbone of the polymer comprises a repeat unit comprising -$Si(R)_2$-O-$Si(R)_2$- where each R independently is methyl or substituted or unsubstituted phenyl. 6 As specific example of such a polymer has general formula:

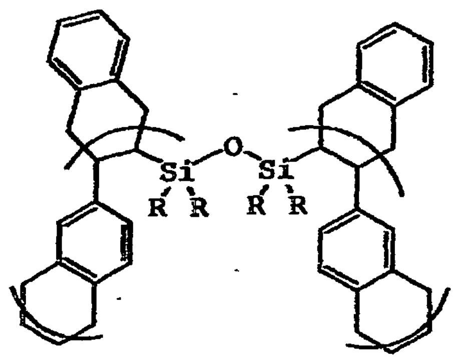

and may be substituted or unsubstituted. This polymer may be made by crosslinking monomers having general formula:

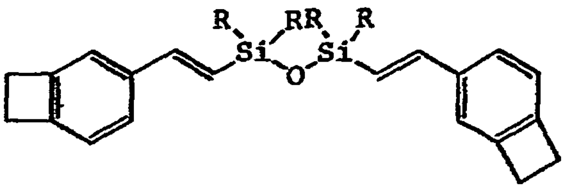

and derivatives thereof, for example bis(benzocyclobutane)-divinyltetramethyldisiloxane (available as Cyclotene®) or a derivative thereof.

In another embodiment, the insulating material preferably comprises an insulating oligomer or insulating small molecule.

In addition to consideration of the above design rules, it is important to select a dielectric material that can form a high quality interface with the adjacent semiconductive layer. The interface desirably is chemically stable, molecularly abrupt and molecularly smooth.

Further the dielectric layer preferably should show high dielectric breakdown strength, and very low electrical conductivity.

Also, the gate dielectric polymer must be compatible with the overall designated processing scheme of organic (particularly polymer) FETs. For example, its formation must not destroy earlier formed layer integrities, while it itself has to survive subsequent solvent and thermal processing (if any).

Further preferably the insulating material has low bulk electrical conductivity and high dielectric breakdown strength.

Also preferably, the insulating material has a glass transition temperature of greater than 120°C, most preferably greater than 150°C.

The bulk resistance of the insulating material preferably is greater than $10^{14}$ Ohm cm, most preferably greater than $10^{15}$ Ohm cm).

The insulating material desirably should be processable into a high-quality defect-free ultrathin film.

The dielectric breakdown strength advantageously may be greater than 1 MV/ cm, preferably greater than 3 Mv/cm.

(a) Preferably, the gate dielectric is thermally and mechanically stable up to 150°C, more preferably up to 300°C. When this is the case, the upper shelf/operating temperature of the device becomes essentially limited by the semiconducting polymer (and the attached electrodes).

In order to impart chemical and mechanical stability, the gate organic gate insulating material in one embodiment preferably is crosslinked.

The dielectric layer may consist of a single layer of a single insulating material or may comprise more than one layer of insulating materials or a blend of insulating materials.

Some examples of suitable semiconductive polymers are: poly(fluorene) homopolymers and copolymers, poly (p-phenylenevinylene) homopolymers and copolymers, poly (oxadiazole) homopolymers and copolymers, poly(quinoxaline) homopolymers and copolymers, and homopolymers and copolymers that include one or more groups selected from perylenetetracarboxylic diimide, naphthalenetetracarboxlic dianhydride, quinoline, benzimidiazole, oxadiazole, quinoxalines, pyridines, benzothiadiazole, acridine, phenazine, and tetraazaanthracene.

The repeat units in the above polymers, and indeed in any semiconductive polymer useable in the present invention, may be substituted or unsubstituted provided that the final semiconductive polymers comply with the above design rules. Substituents include functional substituents to enhance particular properties of the polymer such as solubility.

Crosslinked derivatives of the above semiconductive polymers also are within the scope of the present invention.

Equivalent oligomers of the above polymers are usable in the present invention.

In some embodiments, the semiconductive polymer may be made from a precursor polymer. Such a precursor may be converted to the final semiconductive polymer by appropriate reaction. For example, where the final semiconductive polymer is crosslinked, a precursor semiconductive polymer may contain crosslinkable groups and the crosslinked semiconductive polymer may be formed from the precursor by heating, for example.

Preferably the charge-carrier mobility is as high as possible. Presently, typical values obtainable with the present invention are in the range $10^{-5}$ - $10^{-1}$ $cm^2$ /V s.

Suitable methods for making the present transistor will be known to those skilled in this art. Clearly, processing conditions must be selected so that trapping groups are not present in the dielectric layer above the critical concentration. This will involve the selection of appropriate processing conditions particularly when forming the dielectric layer, for example so that the final dielectric layer does not contain residual units that may act as traps above the critical concentration.

The dielectric layer and the /or the semiconductive layer preferably are formed by solution processing.

Where the insulating material is crosslinked, a solution containing reactant material for making the crosslinked insulating material may be deposited by solution processing. The reactant material is then cured to make the crosslinked insulating material. One common mechanism for curing is a condensation reaction which crosslinks the reactant material. 6 This condensation reaction typically involves the loss of -OH leaving groups from the reactant material. However, where curing proceeds via a condensation reaction with the loss of -OH leaving groups, this typically will not remove all -OH leaving groups that were present in the reactant material. Thus, the final crosslinked insulating material will include residual -OH leaving groups. As described above this is disadvantageous and as such, the reactant material for making the crosslinked insulating material preferably does not include any -OH leaving groups. Preferably, the crosslinking group in the insulating material is derivable from a crosslinkable group in the reactant material that can be cured without the loss of a leaving group. Examples of such reactions include Diels-Alder reactions between a diene and a dienophile (as exemplified by the reaction between benzocyclobutene and alkene), and a hydrosilylation reaction between Si-H and alkene.

To construct an efficient LFET according to the present invention the source and drain electrodes need to be constructed such that efficient electron injection is possible from one of said source and drain contacts, and efficient hole injection is possible from the other of said source and drain electrodes.

We have discovered that some organic semiconductors allow efficient injection of both electrons as well as holes from the same metal contact. For example, we have been able to fabricate ambipolar bottom-gate TFTs with BCB as gate dielectric, poly-3-hexylthiophene as active semiconducting layer, and top-contact calcium source-drain electrodes. Depending on the sign of the gate voltage with respect to the source/drain voltage these devices exhibit ambipolar transport characteristics. Similarly, ambipolar transport has been observed in top-gate poly-dioctylfluorene-co-bithiophene (F8T2) transistors with gold source-drain contacts. Without wanting to be bound by theory the fact that injection of both electrons and holes is possible in this case from the same metal in spite of the relatively large band gap of the semiconductor might be related to the formation of an interfacial dipole or an interfacial chemical reaction between the metal electrode and the organic semiconductor.

According to another embodiment of the present invention an LFET is constructed with a source electrode that comprises a different conducting material than the drain electrode. Preferrably the two metals have different workfunctions. The lower workfunction metal is selected to enable efficient electron injection into the lowest unoccupied molecular orbital (LUMO) of the organic semiconductor, while the higher workfunction metal is selected to enable efficient hole injection into the highest occupied molecular orbital (HOMO). Since the band gap of most organic materials is higher than 1.5eV it is preferable that the work function difference between the two contacts is at least 0.5 eV. More preferably the difference in workfunction between the source and drain metals is higher than 1.0 eV, most preferably the workfunction difference is higher than 1.5 eV. Suitable hole injecting contacts include gold (workfunction 5.0 eV) silver, platinum, palladium, indium tin oxide or conducting polymers such as PEDOT/PSS. Suitable electron injecting contacts are low-workfunction metals such as calcium (workfunction 2.9 eV), magnesium, barium, copper or aluminum.

According to another embodiment the source and drain contacts can be fabricated from the same bulk material, but prepared to exhibit different surface composition as a result of a surface treatment process or a sequence of surface treatment steps which has/have a different effect on the source and the drain electrodes. Modification of a metal electrode,

with self-assembled monolayers can change the workfunction of the electrode significantly.

Depending on the transistor structure which is being used the source and drain contacts (with either different bulk or surface composition) can be fabricated by different methods. In the most common bottom-contact or top-contact thin film transistor structure source and drain contacts are formed in the same plane of the substrate. One method for forming source and drain contacts from different materials is to employ two-step shadow mask evaporation. In a first step the first material, such as a thin film of calcium, is evaporated through a first opening of the shadow mask to define a first electrode, while a second opening separated by a distance L defining the channel length from the first opening is blocked. In a second evaporation step the second material, such as a thin film of gold, is evaporated with the second opening opened up to define the second electrode. During the second evaporation step the first opening might be kept open if the device structure is such that the second material which is evaporated on top of the first material in the area of the first opening does not impede the injection of the respective charges from the first material into the channel of the transistor. In the case of a bottom-gate, top-contact TFT structure, for example, the second material (Au) can then provide some encapsulation to the first material (Ca).

Alternatively, techniques such as two-step photolithography or two subsequent direct-write printing steps, such as, but not limited to, inkjet printing, screen printing, offset printing, laser forward transfer printing or gravure printing can be used. In a first step the first material is deposited and patterned, and then in a second step the second material is deposited and patterned adjacent to the first one in accurate registration with the edge of the first material.

For many applications of LFETs it is desirable that the channel length of the transistor is short, i.e. on the order of a few microns, or even of submicrometer dimension. In this way the transistor ON current (proportional to 1/L) is high, and the intensity of emitted light is high. To define a micron or submicrometer gap between two different electrodes consistently ideally a process is being used which is self-aligned, i.e., the position of the egde of the second electrode with respect to that of the first electrode is defined not by a registration or an alignment step.

One method according to the present invention to define a self-aligned channel length between a low-work-function electrode and a high-workfunction electrode in the same plane of the substrate is based on surface-energy assisted inkjet printing (PCT/GB00/04942). In this method the surface of the substrate is prepatterned into lyophobic and lyophilic surface regions. The channel length is defined by a narrow lyophobic rib separated by two adjacent lyophilic regions on both sides. A first ink comprising a high workfunction metallic material, such as a gold nanoparticle ink or a PEDOT/PSS conducting polymer ink is inkjet printed into the first lyophilic substrate region. The spreading of the ink is confined by the lyophobic rib, such that the ink does not come in contact with the second lyophilic region. Then a second ink comprising a lower workfunction metal is inkjet printed into the second lyophilic region with the lyophobic rib again confining the spreading of the ink. In this way a self-aligned channel is formed with the channel length defined, by the width of the lyophobic rib.

Liquid-based patterning techniques require metallic inks with a low workfimction exhibiting sufficient stability against oxidation during printing/processing. A suitable low-workfunction ink might be a carbon nanotube-based or carbon black dispersion ink. It has been shown that alkali-intercalated carbon nanotube bundles have workfunctions less 4.5 eV suitable for electron injection into many organic semiconductors. Alternative choices include metal nanoparticles or electroless plating inks of low workfunction metals such as copper.

Another preferred method according to the present invention for defining the self aligned channel of an LFET is based on the self-aligned printing technique disclosed in UK0130485.6. The self-aligned printing technique is based on printing a first material onto the substrate, modifying the surface of the first material to expose a repulsive surface to the ink of the second material. In this way a self-aligned gap of sub-100 nm dimension between the two subsequently printed materials, which can be of different bulk or surface composition, can be defined. Rectifying diodes based on the self-aligned printing technique have been described in PCT/GB2004/003879.

Another method for self-aligned, definition of the channel according to the present invention is based on two step evaporation as discussed above, where the second material is evaporated as a collimated beam at an oblique angle, such that a channel is defined by a shadowing effect with a length defined by the angle at which the second material is impinging onto the substrate.

Yet another technique for definition of a submirometer gap between two dissimilar materials is based on underetching of a first metal layer protected by a resist pattern, followed by evaporation of a second material and lift-off of the resist pattern. A related technique for definition of a submicrometer channel length between to identical metal electrode is disclosed in Scheinert et al., Appl. Phys. Lett. 84, 4427 (2004). This technique can be applied analogously to the definition of a gap between two dissimilar materials.

In all of the above techniques care needs to be taken that the low-workfunction metal is processed in such a way that oxidation or other chemical degradation of the reactive low-workfunction surface required for electron injection is avoided. This might require that the processing is performed under inert gas atmosphere, or that the metal is subjected to a final surface treatment or etching step to remove any surface oxide which might have been performed during the processing, before it is brought in contact with the organic semiconductive layer. For techniques where the semiconductor is formed on top of the source-drain structure oxidation will be more easily avoided if the low-workfunction metal is

deposited second.

As active material preferably a material with a high photo/electroluminescence efficiency as well as relatively high field-effect mobilities for both electrons and holes is selected. The material should also be chosen such that efficient electron and hole injection can be achieved with available metal contact materials that have adequate stability under the processing conditions employed. In particular, the electron affinity of the organic semiconducting material is preferably higher than 2.5 eV, more preferably higher than 3 eV, and the ionization potential of the organic semiconductive material is preferrably less than 5.8 eV, more preferably less than 5.5 eV.

Examples for suitable materials are light-emitting polymers, including but not limited to polyfluorene-based systems such as poly-dioctylfluorene (F8), F8T2, or polyphenylenevinylene (PPV) based polymers, such as poly(2-methoxy-5-(3,7-dimethyl)octoxy-p-phenylenevinylene) ("OC1C10-PPV").
Alternatively, other organic materials with efficient photoluminescence known in the literature can be used, including but not limited to small molecule organic semiconductors or light-emitting dendrimers. Other active semiconducting systems include mixtures of several components, for example an organic semiconductive material as a matrix selected for its charge transporting properties with a light-emitting, highly fluorescent or phosphorescent guest chromophore (Baldo, et al., Nature 403, 750 (2000), such as a triplet-emitting dye, and or a blend of high-mobility electron and hole transporting organic semiconductive layers (Appl. Phys. Lett. 85, 1613 (2004)).

To operate an ambipolar FET with a trapping-free dielectric and source and drain contacts which are capable of electron as well as hole injection, respectivel the bias voltage applied to the gate electrode needs to be set at a value in between the voltage applied to the source and drain electrodes. We have found that in LFET constructed according to the present invention (for a detailed device structure see Example 4 below) the recombination zone from which the light is emitted can be made to be located anywhere along the channel of the FET by varying the source, drain and gate voltages accordingly. For example, for a fixed negative gate voltage by increasing the negative drain voltage light-emission from near the drain electrode is first observed when the drain voltage becomes more negative then the gate voltage. At this point the transistor enters into an ambipolar transport regime as evidenced by a sudden increase of the transistor current above the hole saturation current for the respective gate voltage (see Fig. 3c). As the drain voltage becomes more and more negative the well-defined recombination zone can be moved to any position along the channel until it reaches the source electrode.

The present invention allows realization of light-emitting transistors in which the light emission zone is located well away from the source and drain contacts. Depending on the bias voltage the recombination zone can be made to be more than 1 micron, and even more than 5 microns away from both the source and drain electrodes, and can in fact be moved all the way from the source to the drain contact as the source-drain voltage is increased.

The present invention now will be described in further detail with reference to the attached Figures in which :

Figures 1a and 1b show the transfer and output characteristics respectively for a transistor using F8BT as the semiconductive layer in accordance with Example 1;

Figure 1c shows the transfer characteristics for a transistor using CN-PPV as the semiconductive layer in accordance with Example 1;

Figure Id shows the transfer characteristics for a transistor using OC1C10-PPV as the semiconductive layer in accordance with Example 1;

Figure 1e shows the transfer characteristics for a transistor using PPV as the semiconductive layer in accordance with Example 1;

Figures 2a and 2b show the transfer and output characteristics respectively for a transistor using F8BT as the semi conductive layer in accordance with Example 2;

Figures 2c and 2d show the transfer and output characteristics respectively of a transistor using CN-PPV as the semiconductive layer in accordance with Example 2.

Figure 3a shows a schematic diagram of a general LFET (top) and of a specific embodiment (bottom). (1) substrate/gate electrode, (2) dielecric, (3) source electrode, (4) drain electrode, (5) electron channel, (6) hole channel, (7) active organic semiconductor, (8) recombination zone/light emission, (9) heavily doped Si as gate electrode and substrate, (10) 300 nm thermally grown $SiO_2$, (11) 50 nm cured BCB, (12) 40 nm spun $OC_1C_{20}$-PPV, (13) Au electrodes, (14) Ca electrodes, (15) $SiO_x$ encapsulation.

Figure 3b shows the transfer characteristics of an ambipolar OC1C10-PPV transistor with $V_d$=60 V. Electron and

hole transport can be clearly induced for different gate bias.

Figure 3c shows the output characteristics of an ambipolar OC1C10-PPV transistor which is operated in the hole accumulation regime at low $V_d$. When $V_d$ is increased further electrons are injected and cause a steep increase in the output current as indicated by the arrow. We observe light emission from that point onwards.

Figure 3d shows an optical micrograph of a light-emitting transistor in operation. The light emission is observed as a thin line parallel to the electrodes in the middle of the channel (indicated by the arrow). The exact position can be controlled with the applied bias voltages.

Examples

Example 1:

As an illustration of the general principle, a p-doped silicon substrate with 200-nm $SiO_2$ layer is overcoated with a 50-nm-thick BCB layer by spinning a 4-4w/v% BCB (Cyclotene®, The Dow Chemical Company) solution in mesitylene, and then rapid-thermal-annealed on a hotplate set at 290°C 15s under nitrogen ($pO_2$ < 5ppm). The required organic semiconductor is then spin cast over the substrate as a thin film 50-80-nm thick from a 1.3-1.8 w/v% solution in the appropriate solvent. We have' tested with a range of conjugated polymers: (i) poly(9,9-dioctylfluorene-alt-benzo-2-thia-1,3-diazole) ("F8BT") from mixed xylenes, (ii) poly(9,9-dioctylfluorene-2,7-diyl) ("F8") from mixed xylenes, (iii) poly (2,5-dihexyl-p-phenylenevinylene-co-$\alpha$,$\alpha$'-dicyano-2, 5-dihexyl-p-phenylenevinylene) ("CN-PPV") from toluene, (iv) poly(2-methoxy-5-(3,7-dimethyl)octoxy-p-phenylenevinylene) ("OC1C10-PPV") from 1:3 (v/v) THF:toluene and (v) precursor PPV ("PPV") from methanol. 100-nm calcium electrode is deposited through a shadow mask and the electrode encapsulated with 30-nm SiO to give source-drain top-contact electrodes with channel length 25 $\mu$m and width 2.5 mm. Transistors were then tested in glove box.

Representative results are shown in Figs. 1(a)-(e). Figs 1(a) and (b) show the transfer and output characteristics respectively for F8BT. The linear-regime mobility ($\mu_{FET,\,e}$) is estimated to be $5x10^{-3}$ $cm^2$/ Vs. Fig. 1(c) shows the transfer characteristic of CN-PPV ($\mu_{FET,\,e}$ = $3x10^{-5}$ $cm^2$ / Vs). Fig. 1(d) shows the transfer characteristic of OC1C10-PPV ($\mu_{FET,\,e}$ = $4x10^{-5}$ $cm^2$/ Vs). Fig. 1 (e) shows the transfer characteristic of PPV ($5\times10^{-5}$ $cm^2$/ Vs). The PPV and OC1C10-PPV films studied here have a relatively high impurity level which causes a high threshold and drift in device characteristics. F8 has $\mu_{FET,e}$= $1\times10^{-3}$ $cm^2$/ Vs (transfer characteristic not shown).

Without overcoating with the BCB dielectric as in this example, no significant n-channel activity can be observed even after passivating the $SiO_2$ surface with hexamethyldisilazane. This observation is consistent with the high $EA_{rxn}$ expected for the residual silanol groups on the surface of $SiO_2$.

This set of examples is provided to show the principle that appropriate choice of gate dielectric can permit the fabrication of n-channel FETs with a wide range of organic semiconductors so long as the appropriate injection contacts is achieved.

When poly(methyl methacrylate) is used as the gate dielectric (in a top-gate FET), the obtained n-channel FET mobility is very poor, with $\mu_{FET,e}$ typically less than $10^{-6}$ $cm^2$/Vs in the poly(fluorene) derivatives. When poly(vinyl phenol) is used as the gate dielectric, no n-channel FET behaviour can be obtained. When hexamethyldisilazane-treated $SiO_2$ is used as the gate dielectric, no n-channel FET behaviour can be obtained either. All of these observations are consistent with the design rules of the present invention.

Example 2:

As a further illustration of the general principle, this time with aluminium source-drain electrodes: a p-doped silicon substrate with 200-nm $SiO_2$ layer is overcoated with a 50-nm-thick BCB layer by spinning a 4.4w/v% BCB (Cyclotene®, The Dow Chemical Company) solution in mesitylene, and then rapid-thermal-annealed on a hotplate set at 290°C 15s under nitrogen ($pO_2$ < 5ppm). The required organic semiconductor is then spin cast over the substrate as a thin film 50-80-nm thick from a 1.3-1.8 w/v% solution in the appropriate solvent. We have tested with two conjugated polymers: (i) poly(9, 9-dioctylfluorene-alt-benzo-2-thia-1,3-diazole) ("F8BT") from mixed xylenes, and (ii) poly (2,5-dihexyl-p-phenylenevinylene-co-$\alpha$,$\alpha$'-dicyano-2,5-dihexyl-p-phenylene-vinylene) ("CN-PPV") from toluene, 100-nm aluminium electrode is deposited through a shadow mask. Transistors were then tested in glove box.

Representative results are shown in Figs. 2(a)-(d). Figs. 2(a) and (b) show the transfer and output characteristics respectively for F8BT. The linear-regime mobility ($\mu_{FET,\,e}$) is estimated to be $4x10^{-4}$ $cm^2$/ Vs. This is one order of magnitude lower than with Ca electrodes. The output characteristics also saturate too early. Both of these are indicative of high contact resistance with the aluminium electrodes. But nevertheless n-channel activity has still been obtained. Figs. 2(c) and (d) show the transfer and output characteristic of CN-PPV ($\mu_{FET,\,e}$ = $4x10^{-5}$, $cm^2$/ Vs). This is comparable to the Ca

devices and indicate that Al can inject sufficiently well into CN-PPV.

This set of examples is provided to show again the principle that appropriate choice of gate dielectric as discussed in this invention can permit the fabrication of n-channel FETs with a wide range of organic semiconductors with the appropriate injection contacts.

Example 3:

As a further illustration of the general principle, this time with gold source-drain electrodes prepatterned on a glass substrate and with a top gate: the glass substrate is coated with 50-80-nm thick poly(9,9-dioctylfluorene-alt-benzo-2-thia-1,3-diazole) from a 1.7 w/v% solution in mixed xylenes. The gate dielectric layer is then deposited by spinning a 200-nm-thick BCB layer from a 12.7w/v% BCB (extracted from Cyclotene®, The Dow Chemical Company) solution in decane at 30-40°C, and then rapid-thermal-annealed on a hotplate set at 290°C 15s under nitrogen ($pO_2$ < 5ppm). The top-gate electrode is then deposited by printing a surfactant-ion-exchanged poly(3,4-ethylenedioxythiophene)-poly(styrenesulfonate) complex ("PEDT:PSSR"). This surfactant-ion-exchanged PEDT:PSSR complex is made from Baytron P (HC Starck of Leverkusen, Germany) by dialysis exchange with hexadecyltrimethylammomium after enriching the Baytron P with poly(styrenesulfonic acid) to give PEDT:PSS ratio of 10-16.

The electron mobility is ca. $10^{-4}$ $cm^2/Vs$, and is limited by injection. Therefore further improvements can be made by appropriately functionalising the gold electrode to improve its effective work-function, using dipolar self-assembled monolayers.

This example is provided to show that the principles taught in this invention can be applied also to top gate devices with practical injection contacts.

Example 4: Light emitting FET

In order to fabricate an ambipolar light-emitting transistor according to the present invention the same structure as described in example 1 was used with calcium as the drain electrode 14 and gold as the source electrode 13 (Fig. 3a(bottom)). The two metals were evaporated subsequently through a shadow mask with a channel width of 3 mm and a channel length of 100 μm. Calcium was evaporated first through a first window in the shadow mask defining the drain electrode, while a second window in the shadow mask defining the source electrode was blocked off. Gold was then evaporated with both the first and second window opened up. During the second evaporation the calcium contact is capped with gold, which provides some encapsulation of the reactive calcium contact, while not affecting its electron injecting properties. As semiconducting material we used "OC1C10-PPV") spun from an anhydrous mixed isomer xylene solution (5 w%). In contact with BCB OC1C10-PPV combines a high photoluminescence efficiency with relatively high, and well balanced field effect mobilities for electron and holes (hole mobility of $5.10^{-4}$ $cm^2/Vs$, electron mobility of $2.10^{-3}$ $cm^2/Vs$).

Figure 3b shows the transfer characteristics of an ambipolar OC1C10-PPV transistor constructed in this manner with $V_d$=60 V. Electron and hole transport can be clearly induced for different gate bias.

Figure 3c shows the output characteristics of an ambipolar OC1C10-PPV transistor which is operated in the hole accummulation regime at low $V_d$. When $V_d$ is increased further electrons are injected and cause a steep increase in the output current as indicated by the arrow. We observe light emission from that point onwards.

Figure 3d shows two optical micrographs of a light-emitting transistor in operation with different source-drain voltages, and constant gate voltage. The light emission is observed as a thin line parallel to the electrodes in the middle of the channel (indicated by the arrow). The exact position can be controlled with the applied bias voltages. The difference in source-drain voltage between the two images is 2V, and with the more negative value the recombination zone moves closer towards the source electrode.

The present invention is not limited to the foregoing examples.

In view of the foregoing description it will be evident to a person skilled in the art that various modifications may be made within the scope of the invention.

## Claims

1. An ambipolar light-emitting transistor comprising an organic polymer semiconductive layer (7) between an electron injecting electrode (3) and a hole injecting electrode (4), that is capable of emitting light from the semiconductive layer (8) when operated in a biasing regime in which negative electrons (5) are injected from an electron injecting electrode into the organic polymer semiconductive layer and positive holes (6) are injected from a hole injecting electrode into the organic semiconductive layer.

2. An ambipolar light-emitting transistor according to claim 1, wherein the electron injecting electrode and the hole injecting electrode are separated by a distance L defining the channel length of the transistor, in which the zone of the organic polymer semiconductive layer from which the light is emitted is located more than L/10 away from both the electron injecting electrode and the hole injecting electrode.

3. An ambipolar light-emitting transistor according to claim 1, wherein the zone of the organic polymer semiconductive layer from which the light is emitted is located more than 1μm away from both the electron as well as the hole injecting electrode.

4. An ambipolar light-emitting transistor according to claim 1, wherein the zone of the organic polymer semiconductive layer from which the light is emitted is located more than 5μm away from both the electron as well as the hole injecting electrode.

5. A method for biasing an ambipolar light-emitting transistor as defined in any preceding claim, wherein the bias voltage applied to a control gate electrode (1) of the transistor is selected to be in between the bias voltage applied to the hole injecting electrode and that applied to the electron injecting electrode.

6. A method for operating a light-emitting transistor according to any one of claims 1 to 4, wherein the bias voltage applied to a control gate electrode, the bias voltage applied to the hole injecting electrode, and the electron injecting electrode are adjusted to move the recombination zone to a desired position along the channel of the transistor.

7. A circuit, complementary circuit, logic circuit or a display including an ambipolar light-emitting transistor as defined in any one of claims 1 to 4.

## Patentansprüche

1. Ambipolarer lichtemittierender Transistor, aufweisend eine organische Polymer-Halbleiterschicht (7) zwischen einer elektronen-injizierenden Elektrode (3) und einer löcher-injizierenden Elektrode (4), die in der Lage ist, Licht von der Halbleiterschicht (8) zu emittieren, wenn sie in einem Arbeitspunkteinstellungs-Zustand betrieben wird, in dem negative Elektronen (5) von einer elektronen-injizierenden Elektrode in die organische Polymer-Halbleiterschicht injiziert werden und positive Löcher (6) von einer löcher-injinzierenden Elektrode in die organische Halbleiterschicht injiziert werden.

2. Ambipolarer lichtemittierender Transistor nach Anspruch 1, wobei die elektronen-injizierende Elektrode und die löcher-injizierende Elektrode durch einen Abstand L getrennt sind, der die Kanallänge des Transistors definiert, in dem der Bereich der organischen Polymer-Halbleiterschicht, von der das Licht emittiert wird, sich mehr als L/10 von der elektronen-injizierenden Elektrode und von der löcher-injizierenden Elektrode entfernt befindet.

3. Ambipolarer lichtemittierender Transistor nach Anspruch 1, wobei der Bereich der organischen Polymer-Halbleiterschicht, von der das Licht emittiert wird, sich mehr als 1μm von der elektronen-injizierenden sowie von der löcher-injizierenden Elektrode entfernt befindet.

4. Ambipolarer lichtemittierender Transistor nach Anspruch 1, wobei der Bereich der organischen Polymer-Halbleiterschicht, von der das Licht emittiert wird, sich mehr als 5μm von der elektronen-injizierenden sowie von der löcher-injizierenden Elektrode entfernt befindet.

5. Verfahren zum Einstellen eines Arbeitspunkts eines ambipolaren lichtemittierenden Transistors nach einem der vorgehenden Ansprüche, wobei die Vorspannung, die an einer Steuer-Gate-Elektrode (1) des Transistors angelegt wird, so ausgewählt wird, dass sie zwischen der Vorspannung, die an der löcher-injizierenden Elektrode angelegt wird, und der Vorspannung, die an der elektronen-injizierenden Elektrode angelegt wird, liegt.

6. Verfahren zum Betreiben eines lichtemittierenden Transistors nach einem der Ansprüche 1 bis 4, wobei die Vorspannung, die an einer Steuer-Gate-Elektrode angelegt wird, und die Vorspannung, die an der löcher-injizierenden Elektrode und an der elektronen-injizierende Elektrode angelegt wird, eingestellt werden, um den Rekombinationsbereich zu einer gewünschten Position entlang des Kanals des Transistors zu bewegen.

7. Schaltung, Komplementärschaltung, Logikschaltung oder eine Anzeige aufweisend einen ambipolaren lichtemittierenden Transistor nach einem der Ansprüche 1 bis 4.

**Revendications**

1. Transistor photo-émetteur ambipolaire comprenant une couche semiconductrice polymère organique (7) entre une électrode d'injection d'électrons (3) et une électrode d'injection de trous (4), qui est capable d'émettre de la lumière à partir de la couche semiconductrice (8) lors du fonctionnement en un régime de polarisation dans lequel des électrons négatifs (5) sont injectés à partir d'une électrode d'injection d'électrons dans la couche semiconductrice polymère organique et des trous positifs (6) sont injectés à partir d'une électrode d'injection de trous dans la couche semiconductrice organique.

2. Transistor photo-émetteur ambipolaire suivant la revendication 1, dans lequel l'électrode d'injection d'électrons et l'électrode d'injection de trous sont séparées d'une distance L définissant la longueur de canal du transistor, dans lequel la zone de la couche semiconductrice polymère organique de laquelle la lumière est émise, est située à une distance supérieure à L/10 à la fois de l'électrode d'injection d'électrons et de l'électrode d'injection de trous.

3. Transistor photo-émetteur ambipolaire suivant la revendication 1, dans lequel la zone de la couche semiconductrice polymère organique de laquelle la lumière est émise, est située à une distance supérieure à 1 pm à la fois de l'électrode d'injection d'électrons et de l'électrode d'injection de trous.

4. Transistor photo-émetteur ambipolaire suivant la revendication 1, dans lequel la zone de la couche semiconductrice polymère organique de laquelle la lumière est émise, est située à une distance supérieure à 5 pm à la fois de l'électrode d'injection d'électrons et de l'électrode d'injection de trous.

5. Procédé pour la polarisation d'un transistor photo-émetteur ambipolaire tel que défini dans l'une quelconque des revendications précédentes, dans lequel la tension de polarisation appliquée à une électrode de grille de commande (1) du transistor est sélectionnée de manière à être située entre la tension de polarisation appliquée à l'électrode d'injection de trous et celle appliquée à l'électrode d'injection d'électrons.

6. Procédé pour faire fonctionner un transistor photo-émetteur suivant l'une quelconque des revendications 1 à 4, dans lequel la tension de polarisation appliquée à une électrode de grille de commande, la tension de polarisation appliquée à l'électrode d'injection de trous et l'électrode d'injection d'électrons sont ajustées pour déplacer la zone de recombinaison à une position désirée le long du canal du transistor.

7. Circuit, circuit complémentaire, circuit logique ou dispositif d'affichage comprenant un transistor photo-émetteur ambipolaire tel que défini dans l'une quelconque des revendications 1 à 4.

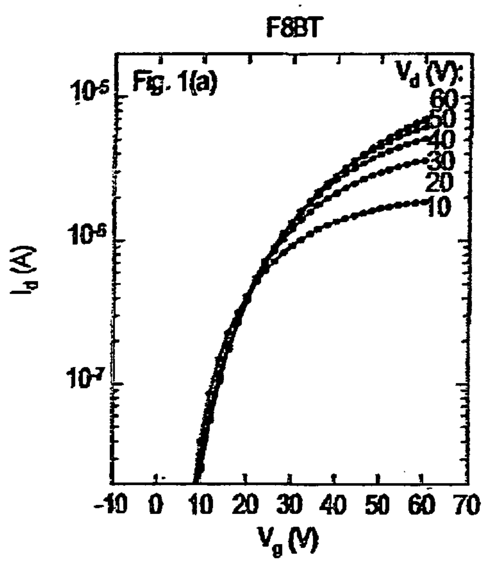
F8BT
Fig. 1(a)
$V_d$ (V):
60
50
40
30
20
10
$10^{-5}$
$10^{-6}$
$10^{-7}$
$I_d$ (A)
-10 0 10 20 30 40 50 60 70
$V_g$ (V)

Figure 1a

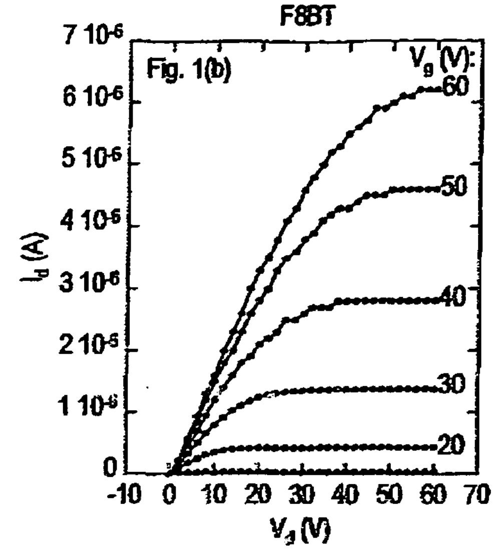


Figure 1b

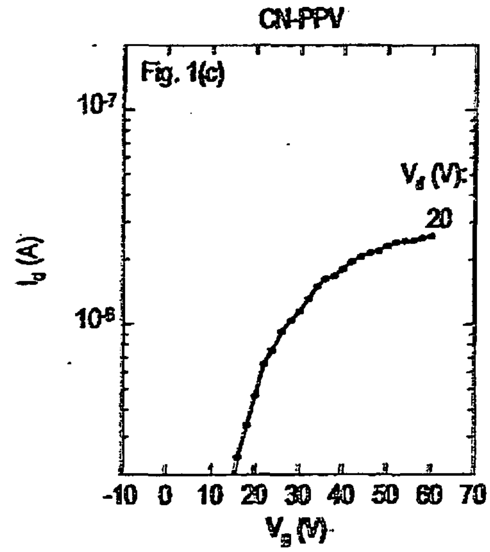


Figure 1c

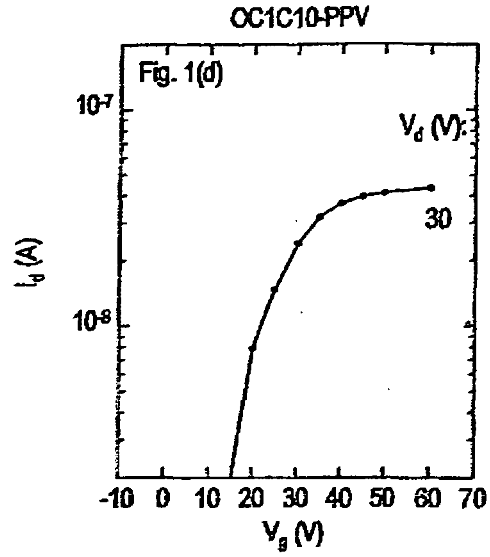


Figure 1d

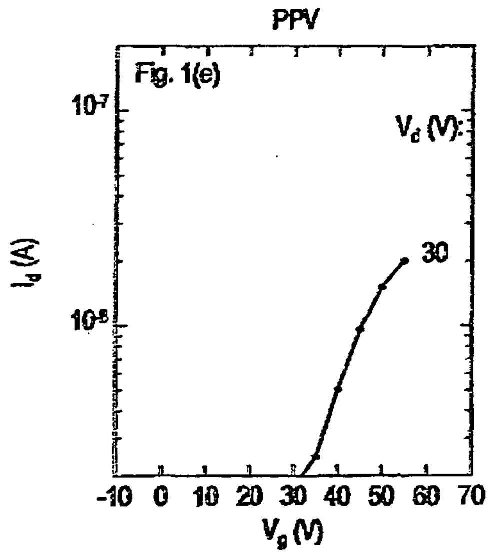


Figure 1e

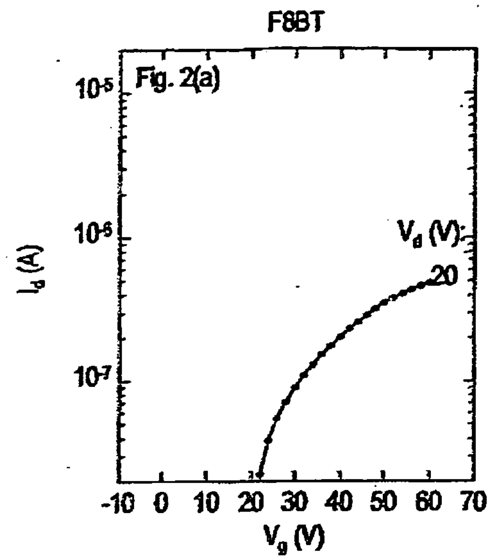


Figure 2a

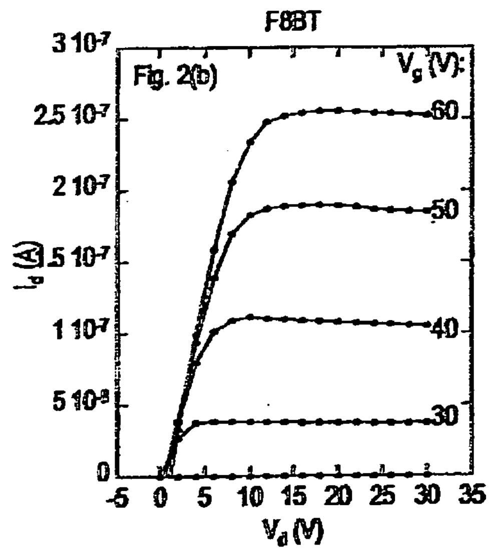


Figure 2b

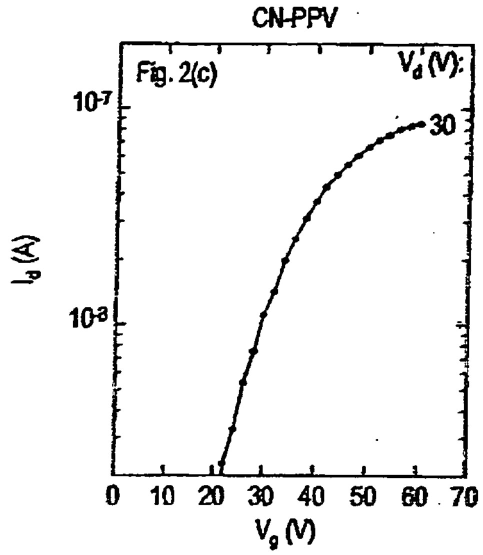


Figure 2c

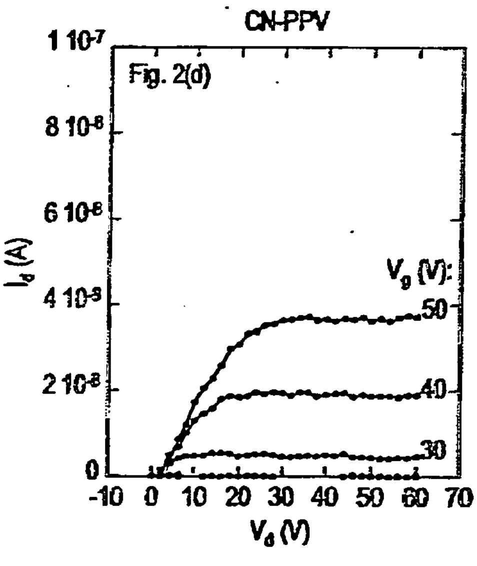


Figure 2d

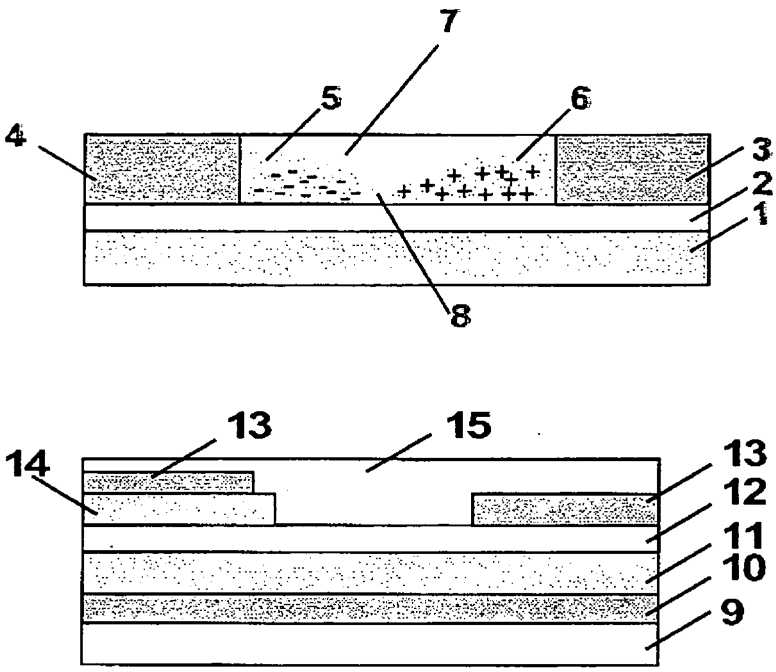


Figure 3a

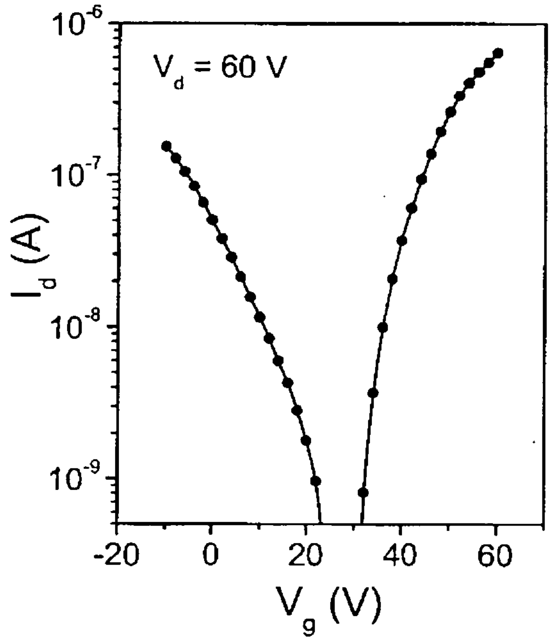


Figure 3b

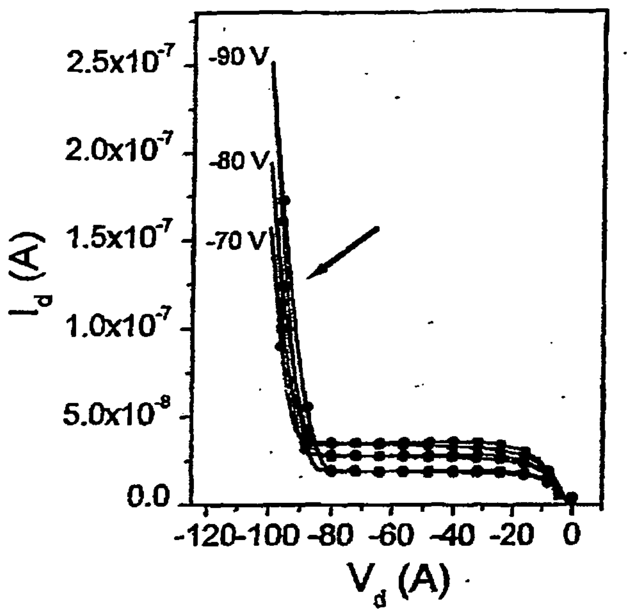


Figure 3c

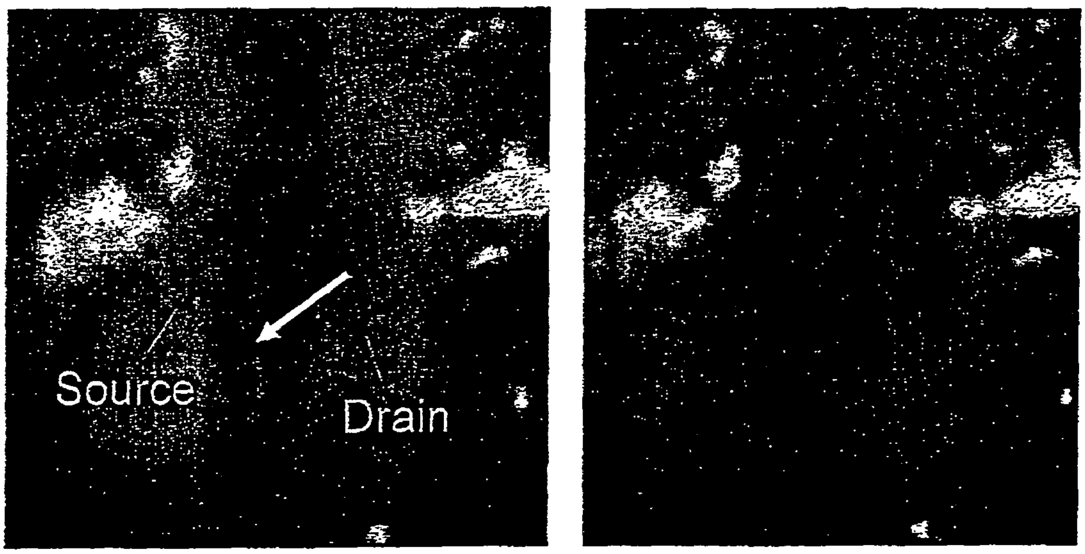


Figure 3d

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- GB 0004942 W
- GB 0130485 A
- GB 2004003879 W


### Non-patent literature cited in the description


- *Advanced Functional Materials,* 2003, vol. 13, 199-204
- **P. HOROWITZ ; W. HILL.** The Art of Electronics. Cambridge University Press, 1989
- **H. PFLEIDERER ; W. KUSIAN ; B. BULLEMER.** *Siemens Forschungs - Und Entwicklungsberichte - Siemens Research and Development Reports,* 1985, vol. 14, 114
- **G- GUILLAUD ; M.A. SADOUND ; M. MAITROT.** *Chemical Physics Letters,* 1990, vol. 167, 503
- **A.R. BROWN ; D.M. DE LEEUW ; E.J. LOUS ; E.E. HAVINGA.** *Synthetic Metals,* 1994, vol. 66, 257
- **J.G. LAQUINDANUM ; H.E. KATZ ; A. DODABALAPUR ; A.J. LOVINGER.** *Journal of the American Chemical Society,* 1996, vol. 118, 11331
- **H.E. KATZ ; A.J. LOVINGER ; J. JOHNSON ; C. KLOC ; T. SIEGRIST ; W. LI ; Y-Y. LIN ; A. DODABALAPUR.** *Nature,* 2000, vol. 404, 478
- **C.D. DIMITRAKOPOULOS ; P.R.L. MALENFANT.** *Advanced Materials,* 2002, vol. 14, 99
- **KATZ et al.** *Nature,* 2000, vol. 404, 478-481
- **A. FACCHETTI ; Y. DENG ; A. WANG ; Y. KOIDE ; H. SIRRINGHAUS ; T. MARKS ; R.H. FRIEND.** *Angewangte Chemie,* 2000, vol. 39, 4545
- **R.J. CHESTERFIELD ; C.R. NEWMAN ; T.M. PAPPENFUS ; P.C. EWBANK ; M.H. HAUKAAS ; K.R. MANN ; L.L. MILLER ; C.D. FRISBIE.** *Advanced Materials,* 2003, vol. 15, 1278
- **A. BABEL ; S.A. JENEKHE.** *Journal of the American Chemical Society,* 2003, vol. 125, 13656
- *Nature Materials,* 2003, vol. 2, 678
- *Science,* 1995, vol. 269, 1560
- **H. SCHOEN et al.** *Science,* 2000, vol. 289, 588
- *Science,* 2000, vol. 290, 963
- **HEPP et al.** *Phys. Rev. Lett.,* 2003, vol. 91, 157406
- **SANTATO et al.** *Synth. Metals,* 2004, vol. 146, 329
- *Appl. Phys. Lett.,* 2004, vol. 85, 1613
- **SAKANOUE.** *Appl. Phys. Lett.,* 2004, vol. 84, 3037
- **SCHEINERT et al.** *Appl. Phys. Lett.,* 2004, vol. 84, 4427
- **BALDO et al.** *Nature,* 2000, vol. 403, 750